(19)

Europäisches
Patentamt

European
Patent Office

Office européen
des brevets

(11) **EP 2 991 088 B1**

(12) **EUROPÄISCHE PATENTSCHRIFT**

(45) Veröffentlichungstag und Bekanntmachung des
Hinweises auf die Patenterteilung:
**19.09.2018   Patentblatt 2018/38**

(51) Int Cl.:
*H01H 3/28* *(2006.01)*          *G01R 31/327* *(2006.01)*
*G01R 19/165* *(2006.01)*        *G01R 31/02* *(2006.01)*
*H01H 23/22* *(2006.01)*         *H01H 47/00* *(2006.01)*
*H01H 51/00* *(2006.01)*         *H01H 73/36* *(2006.01)*

(21) Anmeldenummer: **15182624.5**

(22) Anmeldetag: **27.08.2015**

(54) **ELEKTRISCHER SCHALTER**

ELECTRIC SWITCH

COMMUTATEUR ELECTRIQUE

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: 29.08.2014   DE 102014012555
29.08.2014   DE 102014012589

(43) Veröffentlichungstag der Anmeldung:
**02.03.2016   Patentblatt 2016/09**

(73) Patentinhaber: **Marquardt Mechatronik GmbH
78604 Rietheim-Weilheim (DE)**

(72) Erfinder:
• **Volk, Sebastian
78052 Villingen-Schwenningen (DE)**
• **Maier, Andreas
78737 Fluorn-Winzeln (DE)**

• **Geiger, August
78607 Talheim (DE)**
• **Beckers, Roland
78652 Deisslingen (DE)**
• **Fischinger, Tobias
78628 Rottweil-Göllsdorf (DE)**
• **Mattes, Thomas
78583 Böttingen (DE)**

(74) Vertreter: **Otten, Roth, Dobler & Partner mbB
Patentanwälte
Großtobeler Straße 39
88276 Berg / Ravensburg (DE)**

(56) Entgegenhaltungen:
EP-A2- 1 096 262        EP-A2- 2 405 539
DE-A1-102013 008 128    DE-C1- 4 001 509

EP 2 991 088 B1

**Beschreibung**

Die Erfindung betrifft einen elektrischen Schalter nach dem Oberbegriff des Patentanspruchs 1.

Solche elektrischen Schalter dienen zum Ein- und/oder Ausschalten von elektrischen Geräten durch eine manuelle Betätigung eines Benutzers. Insbesondere werden diese Schalter beispielsweise in der Hausgeräteindustrie für Haushaltsgeräte, wie Kaffeemaschinen, Staubsauger o. dgl., für Geräte in der Unterhaltungsindustrie etc. eingesetzt. Solche Schalter können in der Art eines Wippschalters ausgestaltet sein.

Aus der DE 10 2013 008 128 A1 ist ein derartiger elektrischer Schalter, der ein Gehäuse besitzen kann, bekannt. Im Gehäuse befindet sich ein Kontaktsystem. Aus dem Gehäuse ragt ein bewegliches Betätigungsorgan zum manuellen Umschalten des Kontaktsystems zwischen zwei Schaltstellungen, nämlich einer Ausschalt-Stellung und einer Einschalt-Stellung, heraus. Im Gehäuse befindet sich weiter ein ansteuerbarer Aktor, bei dessen Ansteuerung das Kontaktsystem nichtmanuell in die andere Schaltstellung geschaltet wird. Hierfür ist eine im Gehäuse befindliche, sowie auf einer im Gehäuse befindlichen Leiterplatte angeordnete Elektronik zur Auswertung wenigstens eines Signals vorgesehen, wobei nach Auswertung des Signals eine zur Auswertung korrespondierende Aktion ausgelöst werden kann. Und zwar kann das Kontaktsystem mittels des Aktors insbesondere von der Einschalt- in die Ausschalt-Stellung nichtmanuell geschaltet werden. Weitere nichtmanuelle Funktionen sind für den bekannten Schalter nicht vorgesehen.

Ein weiterer elektrischer Schalter, bei dem das Kontaktsystem ebenfalls mittels eines Aktors von der Einschalt- in die Ausschalt-Stellung nichtmanuell geschaltet werden kann, ist aus der EP 2 405 539 A2 bekannt.

Der Erfindung liegt die Aufgabe zugrunde, den Schalter derart weiterzuentwickeln, dass dessen Funktionalität erhöht ist.

Diese Aufgabe wird bei einem gattungsgemäßen elektrischen Schalter durch die kennzeichnenden Merkmale des Anspruchs 1 gelöst.

Beim erfindungsgemäßen elektrischen Schalter handelt es sich bei dem Signal um ein externes Signal, so dass externe Werte und/oder ein Zustand an den Schalter übermittelt werden können. Hierfür ist ein externer Sensor zur Erfassung und/oder Erzeugung des externen Signals vorgesehen. Der Sensor ist dabei außerhalb des Gehäuses befindlich. Weiter ist ein Eingang zur Erfassung des Signals vorgesehen. In kompakter Art ist der Eingang als ein Anschluss am Gehäuse ausgestaltet. Insbesondere kann es sich bei dem Signal um einen Messwert und bei der Elektronik um einen Mikroprozessor handeln. Dadurch können die verschiedensten Zustände mittels des Signals an den Schalter übermittelt und/oder vom Schalter ermittelt sowie bedarfsweise von der Elektronik ausgewertet werden, so dass vorteilhafterweise die Funktionalität des Schalters erhöht ist. Weitere Ausgestaltungen der Erfindung sind Gegenstand der Unteransprüche.

In weiter Ausgestaltung kann es sich bei der zur Auswertung korrespondierenden Aktion, die nach Auswertung des Signals ausgelöst wird, um die Ansteuerung des Aktors zum Schalten des Kontaktsystems in die andere Schaltstellung und/oder um die Ansteuerung einer optischen Anzeige handeln. Beispielsweise kann die optische Anzeige mittels einer Beleuchtung am Schalter erfolgen, die den der Auswertung des Signals entsprechenden Zustand dem Benutzer signalisiert.

Zum Schutz des Schalters vor schädlichen Einflüssen kann der Schalter zweckmäßigerweise ein Gehäuse zur Aufnahme des Kontaktsystems sowie des Aktors aufweisen. Das Betätigungsorgan ragt für den Benutzer zur manuellen Bedienung zugänglich aus dem Gehäuse heraus. Zwecks kompakter Anordnung sowie zu deren Schutz kann die Elektronik im Gehäuse befindlich sein. Die Elektronik kann zwecks einfacher Montage auf einer im Gehäuse befindlichen Leiterplatte angeordnet sein.

Bei dem Signal kann es sich um ein analoges und/oder ein digitales Signal handeln. Beispielsweise kann es sich bei dem Sensor

- um einen Temperaturfühler zur Erfassung der Temperatur,
- um ein Fotoelement zur Erfassung von Licht,
- um ein Potentiometer zur Erfassung einer Widerstandsänderung und/oder
- um ein externes elektrisches Schaltelement, beispielsweise einen Tastschalter, welcher insbesondere zur benutzergesteuerten Programmierung der Elektronik vorgesehen sein kann,

handeln. Bei dem Signal kann es sich auch um ein internes Signal handeln. Das Signal kann beispielsweise den Stromverbrauch und/oder den Stromverlauf entsprechend den Betriebszuständen eines elektrischen Gerätes und/oder die Einschaltzyklen eines elektrischen Gerätes repräsentieren, womit diese mittels der Elektronik im Schalter zweckgerichtet auswertbar sind.

In kompakter sowie auch funktionssicherer Ausgestaltung kann der ansteuerbare Aktor mit dem Betätigungsorgan in Wirkverbindung stehen. Dadurch kann das Betätigungsorgan in wenigstens einer der beiden Schaltstellungen bei Ansteuerung des Aktors vom Aktor zum Schalten des Kontaktsystems in die andere Schaltstellung bewegt werden.

In bevorzugter Weise handelt es sich bei dem Aktor um einen eine Spule sowie einen Anker aufweisenden Elektromagneten. Die Wirkverbindung zwischen dem Aktor und dem Betätigungsorgan kann mittels des Ankers bewirkt werden, womit eine besonders kompakte Ausgestaltung resultiert. In einfacher Art und Weise kann hierzu der Anker mittels eines Stößels auf das Betätigungsorgan, und zwar bevorzugter weise auf einen Ansatz am Betätigungsorgan, einwirken.

Für eine besonders bevorzugte Ausgestaltung des erfindungsgemäßen elektrischen Schalters ist nachfolgendes festzustellen.

Geschaffen ist ein integriertes, intelligentes, mechanisch und/oder galvanisch trennendes Schaltelement, das nichtmanuell und/oder manuell schaltbar ist, ein sogenannter ECO-Schalter.

Der ECO-Schalter soll immer mehr Funktionen beinhalten, um die Steuerung bzw. Regelung einfacher Haushaltsgeräte zu erleichtern. Dabei soll der Schalter verschiedenste Eingangsgrößen bewerten und/oder darauf reagieren können. Durch den Anschluss externer Sensoren und/oder Schaltelemente sollen Zustände erfasst und von der Intelligenz des Schalters bewertet werden. Somit soll der ECO-Schalter beispielsweise auf folgende Eingangsgrößen reagieren:

- Temperatur durch den Anschluss eines Temperaturfühlers,
- Licht durch den Anschluss eines Fotoelements,
- Widerstandsänderung, z.B. durch den Anschluss eines Potentiometers, und/oder
- Erfassung von Schaltzuständen durch den Anschluss eines externen Tasters, welcher zur benutzergesteuerten Programmierung dienen kann.

Desweiteren können folgende Kenngrößen ohne einen zusätzlichen externen Sensor erfasst werden:

- Stromverbrauch bzw. Stromverläufe durch verschiedene Betriebszustände des den ECO-Schalter beinhaltenden Gerätes sowie
- Einschaltzyklen des Gerätes.

Auf die genannten Messgrößen soll der ECO-Schalter individuell reagieren. Beispielsweise kann dies durch eine optische Anzeige des jeweiligen Zustandes durch die Beleuchtung des Schalters und/oder durch das mechanische bzw. galvanische Trennen des Schaltkontakts des Schalters erfolgen.

Durch den Einsatz eines Mikrocontrollers im ECO-Schalter können verschiedene analoge und/oder digitale Signale gemessen bzw. erfasst werden. Die gemessenen bzw. erfassten Werte können sowohl intern durch Messungen im Schalter, beispielsweise eine Strommessung oder die Bestimmung der Anzahl von Einschaltzyklen, als auch durch den Anschluss eines zusätzlichen externen Sensors erfasst werden. Je nach Verwendung kann der ECO-Schalter durch optische Anzeige und/oder durch die galvanische Trennung des Schaltkontakts auf die Eingangsgrößen reagieren. Die komplette Auswerteintelligenz, das Schaltsystem und gegebenenfalls das optische Anzeigeelement befinden sich in einem Standard-Gehäuse für einen Geräteschalter. Durch diese kompakte Bauweise des ECO-Schalters kann dieser dann einen Standard-Geräteschalter ersetzen und somit in einfacher Weise zusätzliche Funktionen in das Endgerät integrieren.

Die mit der Erfindung erzielten Vorteile bestehen insbesondere darin, dass mittels des erfindungsgemäßen Schalters es ermöglicht ist, Zustände eines Elektrogerätes durch den eingebauten Schalter zu erkennen und/oder auf diese Zustände entsprechend zu reagieren. Die Elektronik zur Erfassung und Auswertung des Geräte-Zustandes kann in kompakter Weise in einem Standard-Schaltergehäuse eines Geräteschalters untergebracht sein. Durch die Verwendung eines erfindungsgemäßen Schalters lassen sich in einfacher Weise zusätzliche Funktionen in das Endgerät integrieren. Komplexe Anforderungen zur Erreichung von Energieeinsparungen können einfach und/oder ohne zusätzlichen Entwicklungs- und/oder Konstruktionsaufwand verwirklicht werden. Da die zusätzlichen Funktionen mittels des erfindungsgemäßen Schalters realisierbar sind, bedeutet dies auch eine Kostenersparnis für das Endprodukt.

Ausführungsbeispiele der Erfindung mit verschiedenen Weiterbildungen und Ausgestaltungen sind in den Zeichnungen dargestellt und werden im folgenden näher beschrieben. Es zeigen

Fig. 1a, b, c       einen elektrischen Schalter in Seiten-, Front- und Unteransicht,

Fig. 2a, b, c       diverse Schnitte durch den elektrischen Schalter aus Fig. 1a, b, c,

Fig. 3       den Schalter aus Fig. 1a, b, c mit geöffnetem Gehäuse, wobei sich der Schalter in der Einschalt-Stellung befindet und der Anker in unterer Endposition ist,

Fig. 4       den Schalter wie in Fig. 3, wobei sich der Schalter in einer Zwischenposition während des Ausschalt-Vorganges befindet und der Anker in Zwischenposition ist,

Fig. 5          den Schalter wie in Fig. 3, wobei sich der Schalter in der Ausschalt-Stellung befindet und der Anker in oberer Endposition ist,

Fig. 6a, b      ein schematisches Schaltbild mit Anschlussbelegung für den Anschluss des elektrischen Schalters,

Fig. 7a, b, c, d, e      diverse Ansichten des Schalters mit Schaltbild gemäß einer abermals weiteren Ausführung, wobei in Fig. 7a die Anschlussbelegung, in Fig. 7b das schematische Schaltbild sowie in Fig. 7c die Baugruppe mit vollständigem Modul zu sehen ist,

Fig. 8a, b      das Schaltbild sowie den Funktionsablauf für den Schalter gemäß einer wiederum weiteren Ausführung, wobei in Fig. 8b die grafische Beschreibung der Strommessung zu sehen ist.

Fig. 9          die Schaltungsanordnung für den Verstärker aus Fig. 8a,

Fig. 10         ein schematisches Blockschaltbild umfassend den Schalter sowie einen externen Sensor entsprechend einem ersten Ausführungsbeispiel,

Fig. 11         ein schematisches Blockschaltbild umfassend den Schalter sowie einen externen Sensor entsprechend einem zweiten Ausführungsbeispiel und

Fig. 12         ein schematisches Blockschaltbild umfassend den Schalter sowie einen externen Sensor entsprechend einem dritten Ausführungsbeispiel.

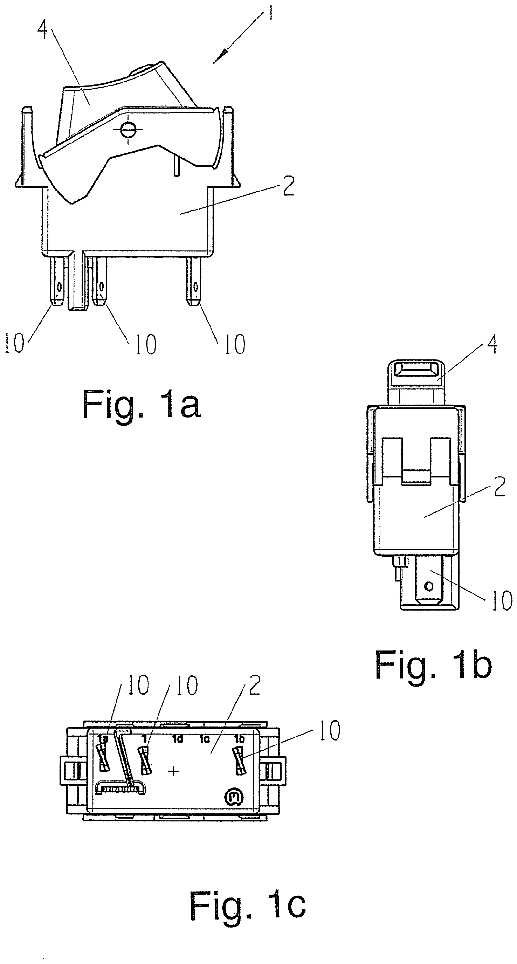

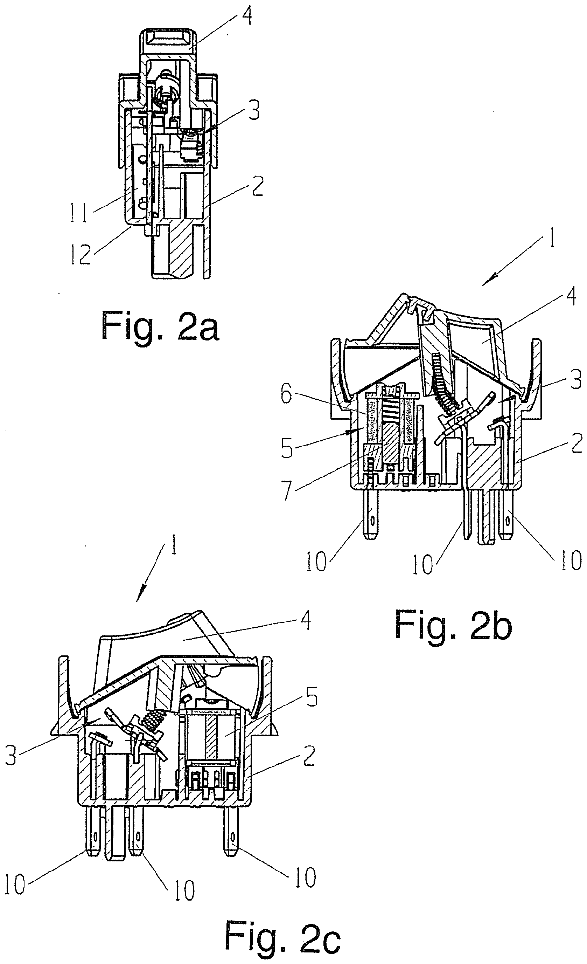

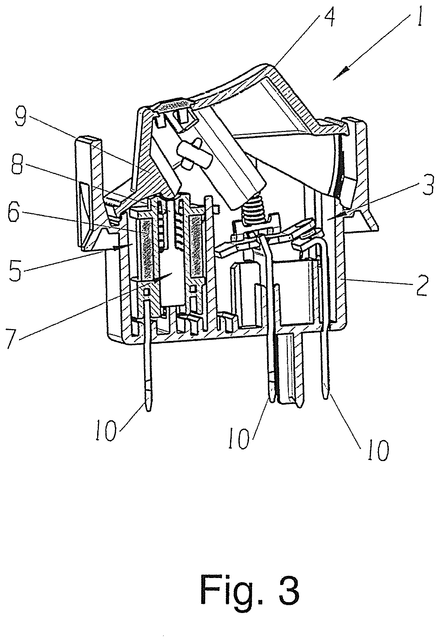

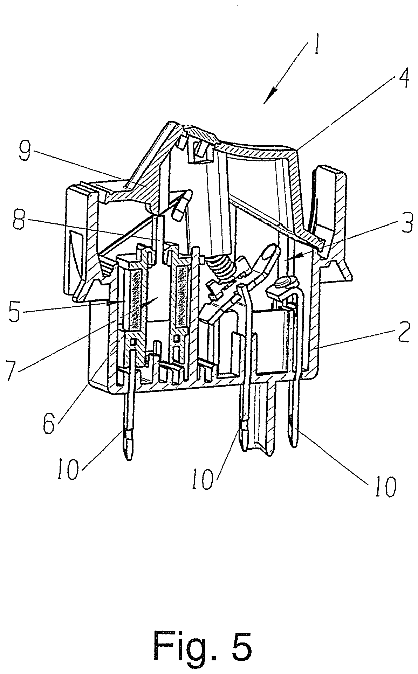

In Fig. 1a, Fig. 1b und Fig. 1c ist ein elektrischer Schalter 1 zu sehen, der als ein Wippschalter ausgebildet ist. Der Schalter 1 besitzt ein Gehäuse 2. Im Inneren des Gehäuses 2 befindet sich ein Kontaktsystem 3, wie in Fig. 2a, Fig. 2b und Fig. 2c zu erkennen ist. Zur Zuführung der elektrischen Spannung zum Kontaktsystem 3 ragen aus dem Gehäuse 2 elektrische Anschlüsse 10 heraus. Der Schalter 1 besitzt weiter ein aus dem Gehäuse 2 herausragendes, bewegliches Betätigungsorgan 4, das vorliegend als Wippe ausgestaltet ist, zum manuellen Umschalten des Kontaktsystems 3 durch den Benutzer zwischen zwei Schaltstellungen, nämlich einer in Fig. 3 gezeigten Einschalt-Stellung sowie einer in Fig. 5 gezeigten Ausschalt-Stellung. Schließlich befindet sich noch ein ansteuerbarer Aktor 5 im Gehäuse 2, der gemäß Fig. 3 mit dem Betätigungsorgan 4 in Wirkverbindung steht, derart dass das Betätigungsorgan 4 in wenigstens einer der beiden Schaltstellungen bei Ansteuerung des Aktors 5 vom Aktor 5 zum Schalten des Kontaktsystems 3 in die andere Schaltstellung bewegt wird. Insbesondere handelt es sich bei dem Schalter 1 um einen sclbstabschaltbarcn Schalter, so dass das Betätigungsorgan 4 vom Aktor 5 von der Einschalt- in die Ausschalt-Stellung des Kontaktsystems 3 bewegt wird. Selbstverständlich kann der Aktor 5 anstelle von dessen Einwirkung auf das Betätigungsorgan 4 auch in sonstiger Weise mit dem Kontaktsystem 3 zu dessen Umschaltung zusammenwirken, was jedoch nicht weiter gezeigt.

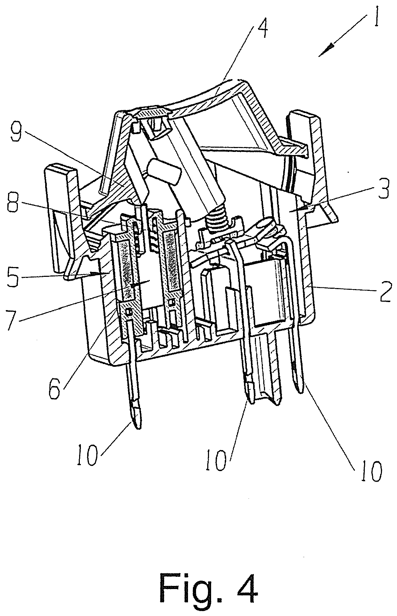

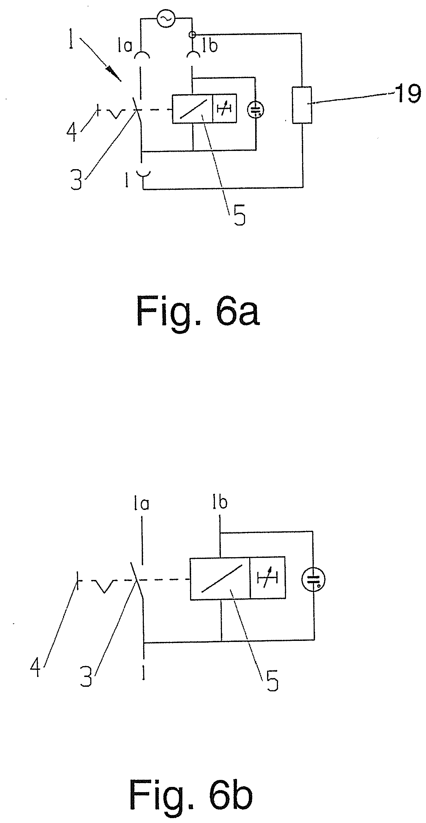

Wie anhand der Fig. 2b zu erkennen ist, handelt es sich bei dem Aktor 5 um einen eine Spule 6 sowie einen Anker 7 aufweisenden Elektromagneten. Die Wirkverbindung zwischen dem Aktor 5 und dem Betätigungsorgan 4 wird mittels des Ankers 7 bewirkt. Hierzu wirkt der Anker 7 mittels eines Stößels 8 auf einen Ansatz 9 am Betätigungsorgan 4 ein, wie dem Ausschaltvorgang beim Selbstabschalten gemäß der Fig. 3 bis Fig. 5 zu entnehmen ist. Das Schaltbild mitsamt Anschlussbelegung für den den Aktor 5 aufweisenden selbstabschaltenden Schalter 1 ist näher in Fig. 6a und Fig. 6b zu sehen. Wie aus der Fig. 6a weiter hervorgeht, wird der die Last 19 enthaltende Lastkreis für den Schalter 1 sowie der Ansteuerkreis für den Aktor 5 mit derselben Spannung betrieben. In einer weiteren Ausführung, die allerdings nicht näher dargestellt ist, wird der Lastkreis des Schalters 1 vom Ansteuerkreis des Aktors 5 getrennt. Dadurch kann dann der Ansteuerkreis mittels Niedervolt betrieben werden. Zur Trennung des Last- und Ansteuerkreises kann ein OptoKoppler verwendet werden.

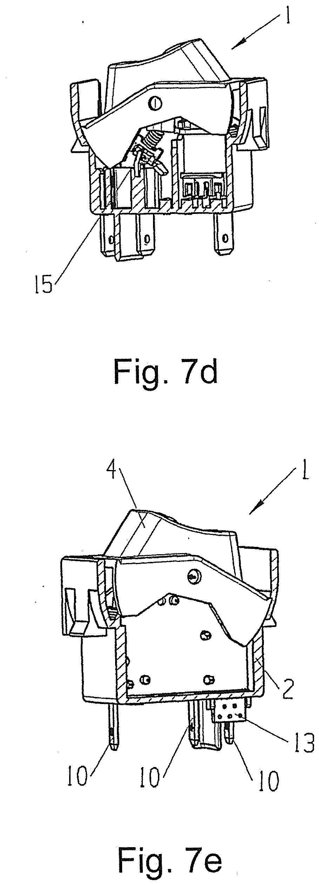

Der Schalter 1 weist eine programmierbare Elektronik 11 auf, wie in Fig. 2a zu sehen ist. Die Elektronik 11 ist auf einer im Gehäuse 2 befindlichen Leiterplatte 12 angeordnet. Die Elektronik 11 umfasst einen Timer zur gesteuerten Bewegung des Betätigungsorgans 4 in die andere Schaltstellung des Kontaktsystems 3. Hierzu weist die Elektronik 11 einen Mikrocontroller bzw. einen Mikroprozessor auf, wobei eine Zeitspanne in der Art einer Abschaltzeit in den Mikrocontroller bzw. den Mikroprozessor programmierbar ist, derart dass die Elektronik 11 bei Ablauf der Zeitspanne den Aktor 5 zum Schalten des Kontaktsystems 3 ansteuert. Zur Programmierung der gewünschten Zeitspanne befindet sich an der Leiterplatte 12 eine Programmierlasche 13, die gemäß Fig. 7e durch einen Schlitz im Gehäuse 2 nach außen geführt ist, derart dass mittels Kontaktierungspunkten an der Programmierlasche 13 das Programmieren des Schalters 1, beispielsweise bei dessen Herstellung, ermöglicht ist.

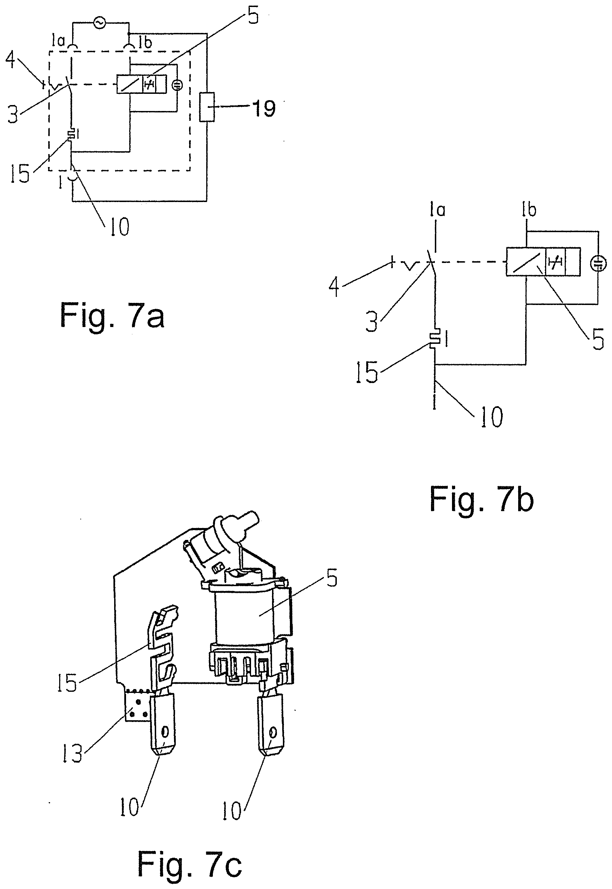

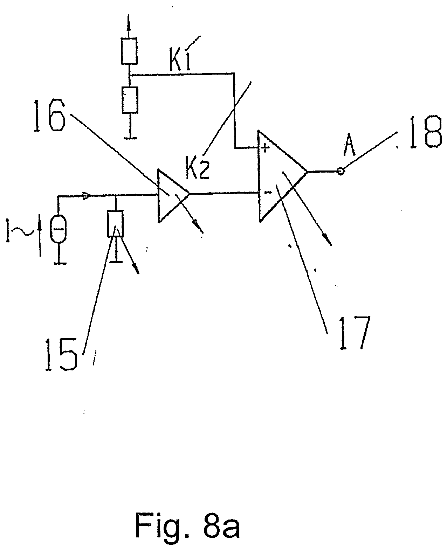

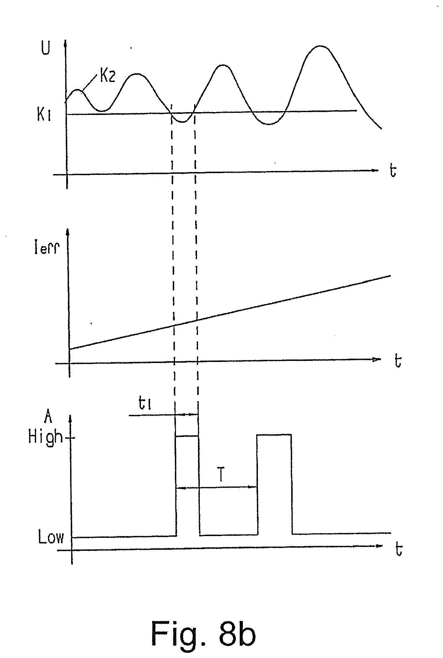

Bei einer weiteren Ausführung, die in Fig. 7a, Fig. 7b, Fig. 7c, Fig. 7d sowie Fig. 7e und Fig. 8a sowie Fig. 8b gezeigt ist, ist ein Mittel zur Messung des durch den Schalter 1 fließenden elektrischen Stroms vorgesehen. Dieses Mittel zur Strommessung umfasst einen Widerstand 15, einen Verstärker 16 sowie einen Komparator 17. Der Widerstand 15 ist gemäß Fig. 7c als eine mäanderförmige Bahn an dem einen elektrischen Anschluss 10 ausgebildet. Wie weiter aus Fig. 8b hervorgeht, wird die Größe des gemessenen Stroms als Tastverhältnis in der Art eines Puls-Weiten-Signals (PWM-Signals) am Ausgang 18 des Komparators 17 ausgegeben. Dabei ist

$$I_{eff} \sim \frac{t_1}{T} = \lambda$$

das Tastverhältnis $\lambda$ am Komparatorausgang A.

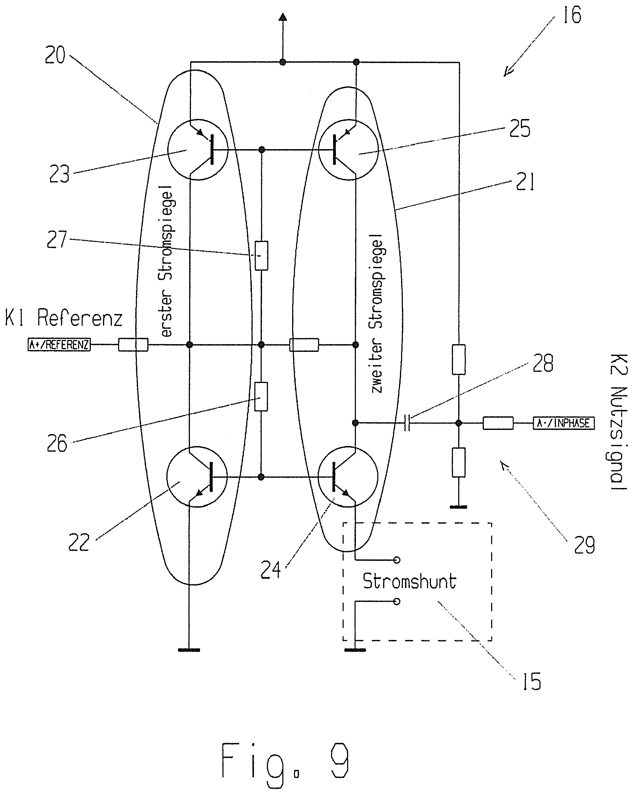

Wie man anhand von Fig. 9 erkennt, in der die nähere Ausgestaltung des Verstärkers 16 sowie dessen Schaltungsanordnung zu sehen ist, besteht der Verstärker 16 aus zwei komplementär aufgebauten Stromspiegeln 20, 21 in der Art eines doppelten Transimpedanzverstärkers. Der Stromspiegel 20, 21 umfasst jeweils zwei Transistoren 22, 23, 24, 25. Eine Reihenschaltung aus zwei Widerständen 26, 27 ist zum Einprägen des Stroms in die Basen der Transistoren 22, 23, 24, 25 der beiden Stromspiegel 20, 21 vorgesehen.

Die Spannung am mittleren Abgriff der Reihenschaltung der beiden Widerstände 26, 27 wird dem gemeinsamen Kollektor der Transistoren 22, 23 des ersten Stromspiegels 20 zugeführt. Der vom gemeinsamen Kollektor der Transistoren 22, 23 des ersten Stromspiegels 20 gebildete Knotenpunkt wird als Referenz K1 verwendet. Die Spannung am mittleren Abgriff der Reihenschaltung der beiden Widerstände 26, 27 wird weiter dem gemeinsamen Kollektor der Transistoren 24, 25 des zweiten Stromspiegels 21 zugeführt. An dem vom gemeinsamen Kollektor der Transistoren 24, 25 des zweiten Stromspiegels 21 gebildeten Knotenpunkt wird über einen Kondensator 28 sowie gegebenenfalls einen weiteren Spannungsteiler 29 das Nutzsignal K2 abgegriffen.

Der Widerstand 15 ist in der Art eines Stromshunts zwischen dem Emitter des einen Transistors 24 des zweiten Stromspiegels 21 und der Masse angeordnet. Ein nicht weiter gezeigter AD(Analog/Digital)-Wandler kann bei Bedarf mit dem Ausgang für das Nutzsignal K2 zur Auswertung des Nutzsignals K2, also für die Bestimmung der Größe des elektrischen Stroms, in Verbindung stehen. Schließlich kann gemäß Fig. 8a ein Komparator 17 mit dem Ausgang für das Referenzsignal K1 sowie mit dem Ausgang für das Nutzsignal K2 zur Auswertung des Differenzsignals zwischen dem Referenzsignal K1 und dem Nutzsignal K2, also für die Bestimmung der Größe des elektrischen Stroms, in Verbindung stehen. Wie bereits erwähnt, kann bei der Auswertung des Nutzsignals K2 und/oder des Referenzsignals K1 ein PWM(Puls-Weiten-Moduliertes)-Signal erzeugt werden, wobei das Tastverhältnis $\lambda$ des PWM-Signals zur Größe des elektrischen Stroms korrespondierend ist.

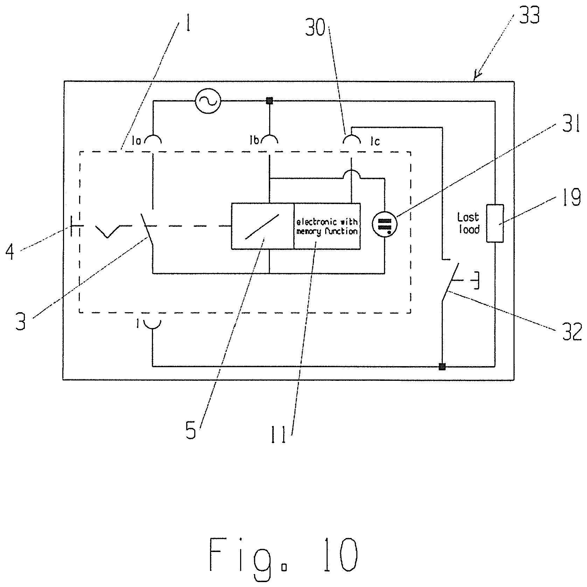

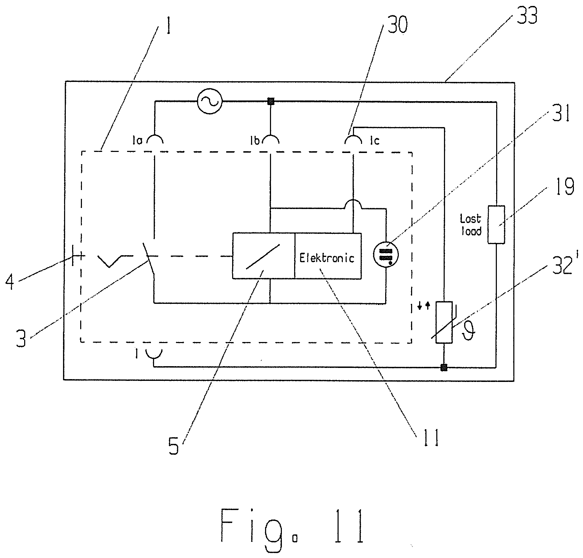

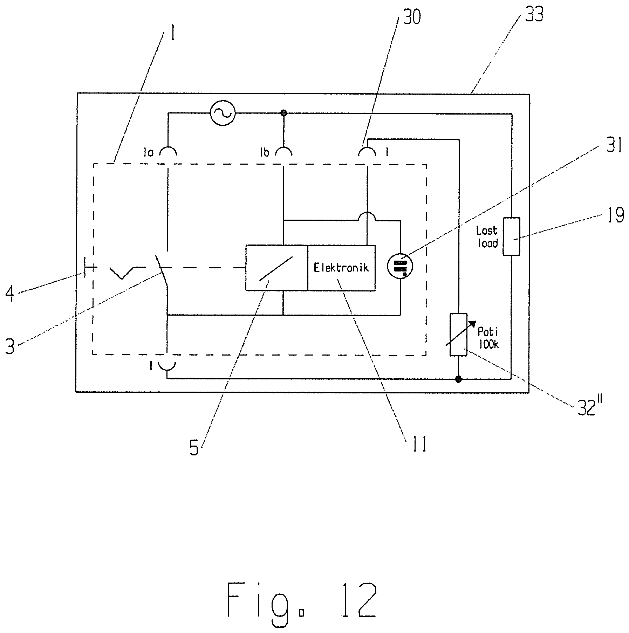

Wie bereits anhand von Fig. 2a ausgeführt, weist der Schalter 1 eine Elektronik 11 auf, die im Gehäuse 2 befindlich ist, und zwar auf einer im Gehäuse 2 befindlichen Leiterplatte 12 angeordnet ist. Am Schalter 1 ist ein in Fig. 10 gezeigter Eingang 30 zur Erfassung wenigstens eines Signals vorgesehen, wobei es sich bei dem Signal insbesondere um einen Messwert handelt. Der Eingang 30 kann als ein Anschluss 10 am Gehäuse 2 ausgestaltet sein. Das Signal wird dann über den Eingang 30 der Elektronik 11 zugeführt, die dann wiederum zur Auswertung des Signals dient. Bevorzugterweise handelt es sich bei der Elektronik 11 um einen Mikroprozessor beziehungsweise die Elektronik 11 umfasst in bevorzugter Weise einen Mikroprozessor. Nach Auswertung des Signals durch die Elektronik 11 wird eine zur Auswertung korrespondierende Aktion ausgelöst. Bei dieser Aktion handelt es sich beispielsweise um die Ansteuerung des Aktors 5 zum Schalten des Kontaktsystems 3 in die andere Schaltstellung und/oder um die Ansteuerung einer optischen Anzeige, die beispielsweise mittels einer in Fig. 10 dargestellten Beleuchtung 31 erfolgt. Bei dem Signal kann es sich um ein analoges und/oder ein digitales Signal handeln. Bevorzugterweise handelt es sich bei dem Signal um ein externes Signal. Hierzu ist ein außerhalb des Gehäuses 2 befindlicher, externer Sensor 32 zur Erfassung und/oder Erzeugung des externen Signals vorgesehen. Als ein erstes Beispiel ist in Fig. 10, in der ein Blockschaltbild zur Integration einer benutzerspezifischen Programmierung des Schalters 1 durch den Anschluss eines externen Tasters an den Schalter 1 gezeigt ist, ein externes elektrisches Schaltelement als externer Sensor 32 zu sehen. Bei dem elektrischen Schaltelement 32 kann es sich beispielsweise um einen Tastschalter handeln, welcher wiederum zur benutzergesteuerten Programmierung der Elektronik 11 vorgesehen sein kann. Mit Hilfe des Schaltelements 32 kann so beispielsweise der weiter oben erwähnte Timer in der Elektronik 11 eingestellt werden. Ein zweites Beispiel in Fig. 11, in der ein Blockschaltbild für die Integration einer Temperaturmessung in den Schalter 1 zu sehen ist, zeigt als Sensor 32' einen Temperaturfühler. Der Temperaturfühler 32' dient zur Erfassung der Temperatur, die dann der Elektronik 11 zur weiteren Auswertung übermittelt wird. Ein drittes Beispiel in Fig. 12, in der ein Blockschaltbild für die Integration einer Widerstandsmessung in den Schalter 1 zu sehen ist, zeigt als Sensor 32" ein Potentiometer. Das Potentiometer 32" dient zur Erfassung einer Widerstandsänderung, die dann der Elektronik 11 zur weiteren Auswertung übermittelt wird. Als weiteres Beispiel für einen Sensor 32, das jedoch nicht weiter gezeigt ist, kann schließlich noch ein Fotoelement zur Erfassung von Licht genannt werden.

Desweiteren kann es sich bei dem Signal auch um ein internes Signal handeln. So kann das Signal den Stromverbrauch und/oder den Stromverlauf entsprechend den Betriebszuständen eines elektrischen Gerätes 33 und/oder die Einschaltzyklen eines elektrischen Gerätes 33, in dem der Schalter 1 verwendet ist, repräsentieren. Die Elektronik 11 kann dieses Signal dann im Hinblick auf die Betriebsdauer des Gerätes 33, die Belastung des Gerätes 33, auf eine erforderliche Wartung des Gerätes 33 o. dgl. auswerten.

Die Erfindung ist nicht auf die beschriebenen und dargestellten Ausführungsbeispiele beschränkt. Sie umfasst vielmehr auch alle fachmännischen Weiterbildungen im Rahmen der durch die Patentansprüche definierten Erfindung. So kann ein derartiger elektrischer Schalter 1 nicht nur für Kaffeemaschinen sondern auch in sonstigen Elektrogeräten, bei denen ein automatisches Um- und/oder Ausschalten ermöglicht sein soll, sowie bei sonstigen Hausgeräten, Gartengeräten, Elektrowerkzeugen o. dgl. Verwendung finden.

Bezugszeichen-Liste:

1: (elektrischer) Schalter
2: Gehäuse
3: Kontaktsystem
4: Betätigungsorgan
5: Aktor
6: Spule
7: Anker
8: Stößel
9: Ansatz (am Betätigungsorgan)
10: (elektrischer) Anschluss
11: Elektronik
12: Leiterplatte
13: Programmierlasche
15: Widerstand / Shunt
16: Verstärker
17: Komparator
18: Ausgang (von Komparator)
19: Last
20,21: Stromspiegel
22,23,24,25: Transistoren (von Stromspiegel)
26,27: Widerstand
28: Kondensator
29: Spannungsteiler
30: Eingang (am Schalter)
31: Beleuchtung (am Schalter)
32: (externer) Sensor / (externes) Schaltelement
32': (externer) Sensor / Temperaturfühler
32": (externer) Sensor / Potentiometer
33: (elektrisches) Gerät
$K_1$: Referenz
$K_2$: Verstärker Stromsignal
A: Ausgang

**Patentansprüche**

1.  Elektrischer Schalter für ein elektrisches Gerät (33) mit einem Kontaktsystem (3) sowie mit einem beweglichen Betätigungsorgan (4) zum Umschalten des Kontaktsystems (3) zwischen zwei Schaltstellungen, wobei es sich bei den Schaltstellungen um eine Einschalt- sowie eine Ausschalt-Stellung handelt, und mit einem ansteuerbaren Aktor (5), bei dessen Ansteuerung das Kontaktsystem (3) in die andere Schaltstellung geschaltet wird, insbesondere von der Einschalt- in die Ausschalt-Stellung des Kontaktsystems (3) geschaltet wird, wobei ein Gehäuse (2) zur Aufnahme des Kontaktsystems (3) sowie des Aktors (5) vorgesehen ist, wobei das Betätigungsorgan (4) zur manuellen Bedienung durch den Benutzer aus dem Gehäuse (2) herausragt, wobei eine Elektronik (11) zur Auswertung wenigstens eines Signals vorgesehen ist, wobei die Elektronik (11) im Gehäuse (2) befindlich ist, wobei die Elektronik (11) auf einer im Gehäuse (2) befindlichen Leiterplatte (12) angeordnet ist, und wobei nach Auswertung des Signals eine zur Auswertung korrespondierende Aktion ausgelöst wird, **dadurch gekennzeichnet, dass** es sich bei dem Signal um ein aus einem Messwert bestehendes, externes Signal handelt, dass ein externer Sensor (32), der außerhalb des Gehäuses (2) befindlich ist, zur Erfassung und/oder Erzeugung des externen Signals vorgesehen ist, und dass ein als ein Anschluss (10) am Gehäuse (2) ausgestalteter Eingang (30) zur Erfassung des Signals vorgesehen ist.

2. Elektrischer Schalter nach Anspruch 1, **dadurch gekennzeichnet, dass** es sich bei der Aktion um die Ansteuerung des Aktors (5) zum Schalten des Kontaktsystems (3) in die andere Schaltstellung und/oder die Ansteuerung einer optischen Anzeige, beispielsweise mittels einer Beleuchtung (31), handelt.

3. Elektrischer Schalter nach Anspruch 1 oder 2, **dadurch gekennzeichnet, dass** es sich bei dem Signal um ein analoges und/oder ein digitales Signal handelt.

4. Elektrischer Schalter nach Anspruch 1, 2 oder 3, **dadurch gekennzeichnet, dass** es sich bei dem Sensor (32) um einen Temperaturfühler (32') zur Erfassung der Temperatur und/oder um ein Fotoelement zur Erfassung von Licht und/oder um ein Potentiometer (32") zur Erfassung einer Widerstandsänderung und/oder um ein externes elektrisches Schaltelement (32), beispielsweise einen Tastschalter, welcher insbesondere zur benutzergesteuerten Programmierung der Elektronik (11) vorgesehen ist, handelt.

5. Elektrischer Schalter nach einem der Ansprüche 1 bis 4, **dadurch gekennzeichnet, dass** der ansteuerbare Aktor (5) mit dem Betätigungsorgan (4) in Wirkverbindung steht, derart dass das Betätigungsorgan (4) in wenigstens einer der beiden Schaltstellungen bei Ansteuerung des Aktors (5) vom Aktor (5) zum Schalten des Kontaktsystems (3) in die andere Schaltstellung bewegt wird.

6. Elektrischer Schalter nach einem der Ansprüche 1 bis 5, **dadurch gekennzeichnet, dass** es sich bei dem Aktor (5) um einen eine Spule (6) sowie einen Anker (7) aufweisenden Elektromagneten handelt, und dass vorzugsweise die Wirkverbindung zwischen dem Aktor (5) und dem Betätigungsorgan (4) mittels des Ankers (7) bewirkt wird, insbesondere indem der Anker (7) mittels eines Stößels (8) auf das Betätigungsorgan (4), bevorzugterweise auf einen Ansatz (9) am Betätigungsorgan (4), einwirkt.

7. Elektrischer Schalter nach einem der Ansprüche 1 bis 6, **dadurch gekennzeichnet, dass** es sich bei dem Schalter (1) um einen Wippschalter handelt, und dass es sich vorzugsweise bei der Elektronik (11) um einen Mikroprozessor handelt.

## Claims

1. An electrical switch for an electrical device (33) comprising a contact system (3) and comprising a movable actuating element (4) for switching the contact system (3) between two switching positions, wherein the switching positions are a switch-on position and a switch-off position, and comprising a controllable actuator (5), in the case of actuation of which the contact system (3) is switched into the other switching position, in particular from the switch-on position into the switch-off position of the contact system (3), wherein a housing (2) is provided for accommodating the contact system (3) and the actuator (5), wherein the actuating element (4) protrudes out of the housing for manual operation (2) by the user, wherein an electronic system (11) is provided for evaluating at least one signal, wherein the electronic system (11) is located in the housing (2), wherein the electronic system (11) is arranged on a printed circuit board (12) located in the housing (2), and wherein after evaluation of the signal an action corresponding to the evaluation is initiated, **characterised in that** the signal is an external signal consisting of a measured value, **in that** an external sensor (32) which is disposed outside the housing (2) is provided for detecting and/or generating the external signal, and **in that** an input (30) configured as a connection (10) on the housing (2) is provided for detecting the signal.

2. The electrical switch according to claim 1, **characterised in that** the action is the actuation of the actuator (5) for switching the contact system (3) into the other switching position and/or actuating an optical display, for example by means of an illumination (31).

3. The electrical switch according to claim 1 or 2, **characterised in that** the signal is an analogue and/or a digital signal.

4. The electrical switch according to claim 1, 2 or 3, **characterised in that** the sensor (32) is a temperature sensor (32') for detecting the temperature and/or is a photo element for detecting light and/or is a potentiometer (32") for detecting a change in resistance and/or is an external electrical switch element (32), for example a push-button switch, which is provided in particular for user-controlled programming of the electronic system (11).

5.  The electrical switch according to one of claims 1 to 4, **characterised in that** the controllable actuator (5) is operatively connected to the actuating element (4) in such a way that when the actuator (5) is actuated, the actuating element (4) in at least one of the two switching positions is moved by the actuator (5) into the other switching position in order to switch the contact system (3).

6.  The electrical switch according to one of claims 1 to 5, **characterised in that** the actuator (5) is an electromagnet comprising a coil (6) and an armature (7), and **in that** preferably the operative connection between the actuator (5) and the actuating element (4) is brought about by means of the armature (7), in particular **in that** the armature (7) acts by means of a tappet (8) on the actuating element (4), preferably on a projection (9) on the actuating element (4).

7.  The electrical switch according to one of claims 1 to 6, **characterised in that** the switch (1) is a rocker switch, and **in that** the electronic system (11) is preferably a microprocessor.

**Revendications**

1.  Interrupteur électrique pour un appareil électrique (33) avec un système de contacts (3) ainsi qu'avec un organe de commande mobile (4) pour commuter le système de contacts (3) entre deux états de commutation, s'agissant quant auxdits états de commutation de l'allumage et de l'extinction, et avec un actionneur commandable (5), lequel, quand il est commandé, commute le système de contacts (3) vers l'autre état de commutation, et singulièrement de l'état d'allumage vers l'état d'extinction du système de contacts (3), un boîtier (2) étant prévu pour loger le système de contacts (3) ainsi que l'actionneur (5), l'organe de commande (4) dépassant du boîtier (2) pour être commandé manuellement par l'utilisateur, un dispositif électronique (11) étant prévu pour analyser au moins un signal, ledit dispositif électronique (11) se trouvant dans le boîtier (2), ledit dispositif électronique (11) étant placé sur une carte de circuits imprimés (12) se trouvant dans le boîtier (2), une action correspondant à l'analyse du signal étant déclenchée après ladite analyse, **caractérisé en ce qu'**il s'agisse quant audit signal d'un signal externe constitué par une valeur mesurée, **en ce qu'**un capteur externe (32), situé à l'extérieur du boîtier (2), soit prévu pour détecter et/ou générer ledit signal externe et **en ce qu'**il soit prévu une entrée (30) sous forme d'un connecteur (10) sur le boîtier (2) pour détecter ledit signal.

2.  Interrupteur électrique selon la revendication 1, **caractérisé en ce qu'**il s'agisse quant à l'action de commander l'actionneur (5) pour commuter le système de contacts (3) vers l'autre état de commutation et/ou de commander un indicateur optique, au moyen d'une illumination (31) par exemple.

3.  Interrupteur électrique selon la revendication 1 ou 2, **caractérisé en ce qu'**il s'agisse quant au signal d'un signal analogique et/ou d'un signal digital.

4.  Interrupteur électrique selon la revendication 1, 2 ou 3, **caractérisé en ce qu'**il s'agisse quant au capteur (32) d'une sonde de température (32') pour détecter la température et/ou d'une cellule photo pour détecter la lumière et/ou d'un potentiomètre (32") pour détecter un changement de résistance et/ou d'un élément de commutation électrique externe (32), tel un bouton-poussoir, lequel est notamment prévu pour la programmation du dispositif électronique (11) par l'utilisateur.

5.  Interrupteur électrique selon une des revendications 1 à 4, **caractérisé en ce que** l'actionneur commandable (5) interagit avec l'organe de commande (4) de telle sorte que l'organe de commande (4) dans au moins un des deux états de commutation lors de la commande de l'actionneur (5) est déplacé par l'actionneur (5) pour commuter le système de contacts (3) vers l'autre état de commutation.

6.  Interrupteur électrique selon une des revendications 1 à 5, **caractérisé en ce qu'**il s'agisse quant à l'actionneur (5) d'un électroaimant présentant un bobinage (6) ainsi qu'un induit (7) et **en ce que** de préférence l'interaction entre l'actionneur (5) et l'organe de commande (4) est opérée au moyen de l'induit (7), en particulier **en ce que** l'induit (7) agisse au moyen d'un poussoir (8) sur l'organe de commande (4), et de préférence sur une saillie (9) sur l'organe de commande (4).

7. Interrupteur électrique selon une des revendications 1 à 6, **caractérisé en ce qu'**il s'agisse quant à l'interrupteur (1) d'un interrupteur à touche basculant et quant au dispositif électronique (11) d'un microprocesseur.

Fig. 1a

Fig. 1b

Fig. 1c

Fig. 2a

Fig. 2b

Fig. 2c

Fig. 3

Fig. 4

Fig. 5

# Fig. 6a

# Fig. 6b

15

Fig. 7a

Fig. 7b

Fig. 7c

## Fig. 7d

## Fig. 7e

Fig. 8a

Fig. 8b

Fig. 9

Lost
load

electronic with
memory function

Fig. 10

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013008128 A1

- EP 2405539 A2